(19)
Europäisches
Patentamt
European
Patent Office
Office européen
des brevets

(11) **EP 3 857 193 B1**

(12) **EUROPÄISCHE PATENTSCHRIFT**


(45) Veröffentlichungstag und Bekanntmachung des Hinweises auf die Patenterteilung:
**29.06.2022 Patentblatt 2022/26**

(21) Anmeldenummer: **19772717.5**

(22) Anmeldetag: **19.09.2019**

(51) Internationale Patentklassifikation (IPC):
***G01K 7/01*** *(2006.01)* ***H03F 3/45*** *(2006.01)*
***G01K 7/16*** *(2006.01)* *B62D 5/04 (2006.01)*

(52) Gemeinsame Patentklassifikation (CPC):
**G01K 7/015; G01K 7/16; H03F 3/45475;**
B62D 5/0496; G01K 2205/00; G01K 2217/00

(86) Internationale Anmeldenummer:
**PCT/EP2019/075116**

(87) Internationale Veröffentlichungsnummer:
**WO 2020/064485 (02.04.2020 Gazette 2020/14)**


(54) **TEMPERATURMESSUNG EINES HALBLEITERLEISTUNGSSCHALTELEMENTES**

TEMPERATURE MEASUREMENT OF A POWER SEMICONDUCTOR SWITCHING ELEMENT

MESURE DE TEMPÉRATURE D’UN ÉLÉMENT DISJONCTEUR À SEMI-CONDUCTEUR


(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **27.09.2018 DE 102018123903**

(43) Veröffentlichungstag der Anmeldung:
**04.08.2021 Patentblatt 2021/31**



(73) Patentinhaber:
- **thyssenkrupp Presta AG**
  **9492 Eschen (LI)**
- **thyssenkrupp AG**
  **45143 Essen (DE)**

(72) Erfinder: **BALÁZS, Vargha**
**1161 Budapest (HU)**

(74) Vertreter: **thyssenkrupp Intellectual Property GmbH**
**ThyssenKrupp Allee 1**
**45143 Essen (DE)**



(56) Entgegenhaltungen:
**EP-A1- 2 575 255** **DE-A1-102008 063 806**
**US-A1- 2015 092 819**

- **LOSMANDY ET AL: "Operational Amplifier Applications for Audio Systems", JOURNAL OF THE AUDIO ENGINEERING SOCIETY, AUDIO ENGINEERING SOCIETY, NEW YORK, NY, US, Bd. 17, Nr. 1, 1. Januar 1969 (1969-01-01) , Seiten 14-21, XP009102774, ISSN: 1549-4950**



Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).


EP 3 857 193 B1

## Beschreibung

Die vorliegende Erfindung betrifft eine Anordnung aufweisend ein Halbleiterleistungsschaltelement und eine Einrichtung zur Bestimmung einer Temperatur des Halbleiterleistungsschaltelementes mit den Merkmalen des Anspruchs 1 und Verfahren zur Messung einer Temperatur eines Halbleiterleistungsschaltelementes mit den Merkmalen der derAnsprüche 9 und 10.

Leistungselemente haben eine nicht unerhebliche Verlustleistung, die bewirkt, dass sich die Chips auf eine Temperatur aufheizen, die erheblich höher sein kann als die Umgebungstemperatur. Die Sperrschichttemperatur ist die wichtigste zu begrenzende Größe eines Leistungsschalters. Das Verhalten von Leistungselementen wie Leistungsschalter wird durch zu hohe Temperaturen negativ beeinflusst. Wird eine maximal zulässige Temperatur überschritten droht ein thermischer Event im betreffenden Bauteil und das Bauteil funktioniert nicht mehr korrekt oder fällt völlig aus.

Die Offenlegungsschrift DE 10 2014 204 648 A1 offenbart ein Verfahren zur Bestimmung einer Temperatur eines Bipolartransistors mit isolierter Gate-Elektrode (IGBT). Ein Treiber zur Bereitstellung einer ersten Steuerspannung am Gate des IGBT und einen Steuerspannungsgenerator zur Bereitstellung einer zweiten Steuerspannung am Gate des IGBT sind vorgesehen, wobei der Treiber und der Steuerspannungsgenerator dazu eingerichtet sind, alternierend betrieben zu werden, sodass stets nur eine der Steuerspannung am Gate anliegen. Die zweite Steuerspannung umfasst einen Gleichspannungsanteil und einen überlagerten Wechselspannungsanteil derart, dass der IGBT im Sperrbetrieb gehalten ist. Für die Wechselspannung ist eine parasitäre Kapazität durchlässig, obwohl der IGBT im Sperrzustand verbleibt. Der Gate-Strom fließt durch den temperaturabhängigen Eingangswiderstand, sodass der Gate-Strom bei einer vorbestimmten Steuerspannung und einer vorbestimmten Amplitude der Wechselspannung ein Maß für die Temperatur des IGBT darstellt, wodurch die Temperatur des IGBT bestimmt werden kann.

DE 10 2012 102 788 A1 offenbart eine Messung der Sperrschichttemperatur eines MOSFETs, wobei onboard eine Diode vorgesehen ist, deren Kathode intern mit der Source des MOSFET verbunden ist, wodurch die Anzahl der herausgeführten Anschlüsse und die Chipfläche des Bauteils verringert werden können. Die Diode ist direkt mit der Sperrschicht des MOSFET gekoppelt, wodurch eine direkte Messung der Sperrschichttemperatur des MOSFTs ermöglicht wird. Zur Bestimmung der Sperrschichttemperatur wird ein Strom verwendet mit dem die Diode in Vorwärtsrichtung betrieben wird. Durch den Stromfluss durch die Diode wird eine Vorwärtsspannung über die Diode erzeugt, die temperaturabhängig und stromabhängig ist. Diese Spannung kann zwischen der Anode der Diode und dem Sourceanschluss des MOSFETs gemessen werden.

Die bekannten Temperaturmessungen sind größtenteils von der Stromstärke abhängig, was insbesondere bei der Verwendung der Halbleiterleistungsschaltelemente in Motorsteuereinheiten zu Ungenauigkeiten in der Temperaturbestimmung führt.

Aus der DE 10 2008 063 806 A1 ist zudem ein Verfahren zur Messung einer Temperatur eines Halbleiterleistungsschaltelementes aufweisend einen eingebauten temperaturabhängigen Gatewiderstand und einen Eingangskondensator bekannt.

Weiter ist aus der EP 2 575 255 A1 ein alternatives Verfahren zur Ermittlung der Temperatur eines Halbleiterschalters, der einen integrierten elektrischen Gatewiderstand und eine parasitäre Gate-Emitter-Kapazität aufweist, bekannt.

Ein weiteres alternatives Verfahren zur Messung der Temperatur eines Halbleiterleistungsschaltelements ist aus der US 2015/092819 A1 bekannt. Das Verfahren basiert dabei auf der Verwendung einer Diode zur Temperaturerfassung, wobei ein temperaturabhängiger Spannungsabfall in der Diode durch eine nicht-invertierende Verstärkerschaltung verstärkt wird.

Eine nicht-invertierende Verstärkerschaltung mit einem Operationsverstärker und einem Gegenkopplungs-Widerstand ist zudem bekannt aus LOSMANDY ET AL: "Operational Amplifier Applications for Audio Systems", JOURNAL OF THE AUDIO ENGINEERING SOCIETY, AUDIO ENGINEERING SOCIETY, NEW YORK, NY, US, Bd. 17, Nr. 1, 1. Januar 1969 (1969-01-01), Seiten 14-21, ISSN: 1549-4950.

Es ist Aufgabe der vorliegenden Erfindung eine 2. Anordnung aufweisend ein Halbleiterleistungsschaltelement und eine Einrichtung zur Bestimmung einer Temperatur des Halbleiterleistungsschaltelementes anzugeben, die die Temperatur unabhängig von der Stromstärke des geschalteten Stroms besonders genau und zuverlässig bestimmt.

Diese Aufgabe wird von einer Anordnung aufweisend ein Halbleiterleistungsschaltelement und eine Einrichtung zur Bestimmung einer Temperatur des Halbleiterleistungsschaltelementes mit den Merkmalen des Anspruchs 1 und einem Verfahren zur Bestimmung einer Temperatur eines Halbleiterleistungsschaltelementes mit den Merkmalen der Ansprüche 9 und 10 gelöst.

Demnach ist eine Einrichtung zur Bestimmung einer Temperatur eines Halbleiterleistungsschaltelementes aufweisend den Halbleiterleistungsschalter mit einem eingebauten temperaturabhängigen Gatewiderstand vorgesehen, wobei die Einrichtung eine nicht-invertierende Verstärkerschaltung, umfassend einen Operationsverstärker und einen Gegenkopplungs-Widerstand, aufweist, wobei der Operationsverstärker derart an den Halbleiterleistungsschalter angeschlossen ist, dass die Verstärkung nicht-invertierenden Verstärkerschaltung in einem vorgegeben Frequenzbereich eines Eingangssignals von dem eingebauten temperaturabhängigen Gatewiderstand und dem Gegenkopplungs-Widerstand abhängt und ein Maß für die Temperatur des Halbleiterleistungsschaltelementes ist.

Die Messung der Temperatur mittels der genauestens bekannten Temperaturabhängigkeit des Gatewiderstandes ist besonders zuverlässig und unabhängig von der Stromstärke. Die berechnete Temperatur ist ein gutes Maß für die Temperatur der Sperrschicht des Halbleiterleistungsschalters. In dem vorgegeben Frequenzbereich zeigt die Verstärkung eine Abhängigkeit von der Temperatur des Gatewiderstands. Es ist bevorzugt, dass die Eingangsimpedanz von dem Halbleiterleistungsschalter nur bzw. im Wesentlichen durch den Gatewiderstand gebildet ist. Dieser Fall ist besonders vorteilhaft, da die Verstärkung dann die größte Abhängigkeit von der Temperatur des Gatewiderstands zeigt und eine Änderung der Temperatur einfach und genau zu messen ist.

Vorzugsweise ist der Gegenkopplungs-Widerstand zwischen dem negativen Eingang und dem Ausgang des Operationsverstärkers und/oder der temperaturabhängige Gatewiderstand zwischen dem negativen Eingang des Operationsverstärkers und einer Referenz-Spannung (normalerweise Masse) der Einrichtung angeordnet.

Der vorgegebene Frequenzbereich liegt vorzugsweise oberhalb einer Frequenz einer Polstelle einer Übertragungsfunktion einer idealen nicht-invertierenden Verstärkerschaltung.

Das Halbleiterleistungsschaltelement ist bevorzugt ein Leistungs-MOSFET oder ein IGBT.

Weiterhin ist eine elektromechanische Kraftfahrzeuglenkung mit einem mehrphasigen permanent erregten Elektromotor, der über eine elektronische Steuereinheit ansteuerbar ist, wobei die elektronische Steuereinheit eine Vielzahl an Halbleiterleistungsschaltelemente aufweist, die Teil eines Inverters sind, vorgesehen, wobei jedes der Halbleiterleistungsschaltelemente eine zuvor beschriebene Einrichtung zur Bestimmung einer Temperatur des jeweiligen Halbleiterleistungsschaltelementes aufweist. Das System kann auch das Schalten von Halbleiterrelais für jede Phase umfassen und kann Mittel zum Bestimmen einer oben beschriebenen Temperatur umfassen, die das jeweilige Halbleiter-Leistungsschaltelement aufweisen. In einer bevorzugten Ausführungsform ist der Elektromotor dreiphasig und weist zwei Halbleiterleistungsschaltelemente pro Phase in einer Halbbrückenschaltung auf, die mittels Pulsweitenmodulation ansteuerbar sind. Andere Sicherheitsrelais können enthalten sein oder auch nicht.

Weiterhin ist ein Verfahren zur Messung einer Temperatur eines Halbleiterleistungsschaltelementes aufweisend einen eingebauten temperaturabhängigen Gatewiderstand vorgesehen, wobei eine nicht-invertierende Verstärkerschaltung aufweisend einen Operationsverstärker und einen Gegenkopplungs-Widerstand, der zwischen dem negativen Eingang und dem Ausgang des Operationsverstärkers angeordnet ist, wobei der temperaturabhängige Gatewiderstand zwischen dem negativen Eingang des Operationsverstärkers und einem negativen Eingang oder einen Referenzeingang der Gesamtschaltung angeordnet ist, und wobei das Verfahren folgende Schritte aufweist:

- Betreiben der Gesamtschaltung mit einem Eingangssignal aufweisend eine Frequenz, die in einem vorgegeben Frequenzbereich liegt, so dass der eingebaute temperaturabhängige Gatewiderstand einen wesentlichen Teil der Eingangsimpedanz des Halbleiterleistungsschalters bildet,
- Messen der Verstärkung der nicht-invertierenden Verstärkerschaltung,
- Berechnen des Widerstandes des eingebauten temperaturabhängigen Gatewiderstands mittels der gemessenen Verstärkung und Bestimmen der Temperatur des Halbleiterleistungsschaltelementes.

Eine andere Möglichkeit besteht darin, das System zu kalibrieren, da das Ausgangssignal eine genau definierte Abhängigkeit vom Wert des GateWiderstands hat:

- Betreiben der Gesamtschaltung mit einem Eingangssignal mit einer Frequenzkomponente, die in einem vorbestimmten Frequenzbereich liegt, so dass sich der eingebaute temperaturabhängige Gate-Widerstand eines wesentlichen Teils der Eingangsimpedanz des Halbleiterleistungsschalters ausbildet,
- Messen des Ausgangssignals des nicht invertierenden Verstärkers bei wenigstens zwei Temperaturwerten,
- Berechnen der Temperaturabhängigkeit des Ausgangssignals basierend auf dem a-priori-Wissen,
- Bestimmen der Temperatur des Halbleiterleistungsschalters basierend auf dem tatsächlichen Ausgangssignal und der vorher bestimmten Temperaturabhängigkeit.

Die beiden Verfahren erlauben die Temperatur des

Halbleiterleistungsschaltelementes unabhängig von der Stromstärke des geschalteten Stroms besonders genau und zuverlässig zu bestimmen.

Die bestimmte Temperatur ist ein Maß für die Sperrschichttemperatur des Halbleiterleistungsschaltelementes.

Vorzugsweise ist das Halbleiterleistungsschaltelement ein Leistungs-MOSFET oder IGBT.

Der vorgegebene Frequenzbereich liegt oberhalb einer Frequenz einer Polstelle einer Übertragungsfunktion einer idealen nicht-invertierenden Verstärkerschaltung.

Zwei bevorzugte Ausführungsformen der Erfindung werden nachfolgend anhand der Zeichnungen näher erläutert. Gleiche bzw. funktionsgleiche Bauteile sind dabei figurübergreifend mit denselben Bezugszeichen versehen. Es zeigen:

Fig. 1: ein Schaltbild einer Einrichtung zur Bestimmung einer Temperatur eines Leistungsschaltelementes mit einem Leistungsschalter und einer nichtinvertierenden Verstärkerschaltung,

Fig. 2: ein Schaltbild einer Einrichtung zur Bestimmung einer Temperatur eines Leistungs-MOSFET, sowie

Fig. 3: ein Diagramm mit Übertragungsfunktion einer idealen und einer realen nicht-invertierenden Verstärkerschaltung.

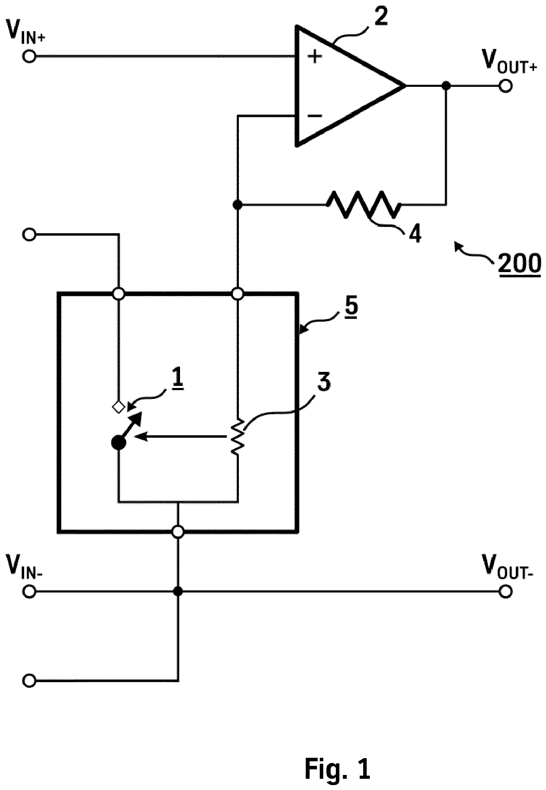

In der Figur 1 ist eine Schaltung mit einem Leistungs-MOSFET 5, der als Halbleiterleistungsschaltelement 5 fungiert, aufweisend einen Halbleiterleistungsschalter 1 mit einem eingebauten Gatewiderstand 3 dargestellt. Der Halbleiterleistungsschalter 1 weist eine nicht dargestellte Parallelschaltung von einer Vielzahl an einzelnen Halbleiterschaltern angeordnet auf einem gemeinsamen Chip auf. Ein bedeutender Vorteil der Halbleiterleistungsschalter 1 ist die hohe mögliche Schaltfrequenz, die zum Beispiel für Pulsweitenmodulation in einer Motorsteuerung vorteilhaft ist. Der Leistungs-MOSFET 5 weist einen eingebauten Gatewiderstand 3 auf, der dazu vorgesehen ist, die Stromverteilung zwischen den einzelnen Halbleiterschaltern auf einem Chip auszugleichen, um parasitäre Schwingungen zu vermeiden und um den Qualitätsfaktor einer möglichen RLC-Reihenschaltungen am Eingang zu senken. Der eingebaute Gatewiderstand 3 ist Teil einer Eingangsimpedanz des Leistungs-MOSFET 5. Der eingebaute Gatewiderstand 3 weist eine bekannte Temperaturabhängigkeit auf, die ein Maß für die Temperatur der Sperrschicht des Halbleiterleistungsschaltelementes 5 ist. Die temperaturabhängige Änderung des Widerstandes des Gatewiderstands 3, wird mittels einer nichtinvertierenden Verstärkerschaltung 200, die einen Operationsverstärker 2, einen Gegenkopplungswiderstand 4 und den eingebauten Gate-Widerstand 3 umfasst, detektiert. Der Halbleiterleistungsschalter 1 mit seiner Eingangsimpedanz ist zwischen dem negativen Eingang des Operationsverstärkers 2 und einem Sollwerteingang der kompletten Schaltung VIN- angeordnet.

Die zu verstärkende Spannung $V_{IN+}$ des Sollwerteingangs des Operationsverstärkers 2 wird an den nicht-invertierenden, positiven Eingang des Operationsverstärkers 2 gelegt. Von der Ausgangsspannung $V_{OUT+}$ des Operationsverstärkers 2 wird durch Spannungsteilung mittels zweier Widerstände ein Bruchteil an den invertierenden, negativen Eingang als Gegenkopplung zurückgeführt. Der Gegenkopplungs-Widerstand 4 ist zwischen dem negativen Eingang des Operationsverstärkers und dem Ausgang angeordnet.

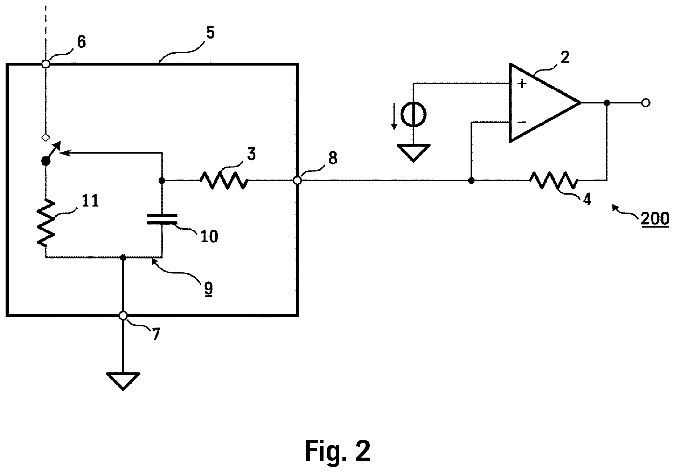

Die Eingangsimpedanz des Halbleiterleistungsschalters 1 kann mittels einer RC-Reihenschaltung (siehe Figur 2) mit einem Eingangskondensator und einem Eingangswiderstand modelliert werden. Bei einem bestimmten Eingangssignal kann die Reihenkapazität der RC-Reihenschaltung als Kurzschluss angesehen werden, so dass die Eingangsimpedanz nur von dem eingebauten Gatewiderstand 3 gebildet ist. Die Verstärkung der nicht-invertierenden Verstärkerschaltung 200 hängt von einer Frequenz f ab. Bei Frequenzen oberhalb einer Grenzfrequenz $f_P$ wird die Eingangsimpedanz von dem eingebauten Gatewiderstand 3 gebildet. Die Impedanz des Kondensators 10 wird abgesenkt und kann als Abkürzung betrachtet werden. Mit steigender Frequenz ist dieser Effekt mehr und mehr beobachtbar.

Die Grenzfrequenz $f_P$ wird unter Verwendung der folgenden Formel berechnet:

$$f_P = \frac{1}{2\pi C_{GS} R_G}$$

Wobei $C_{GS}$ der Eingangskondensator 10, $R_G$ der Gatewiderstand 3 (siehe Figur 2) ist.

In diesem Fall muss der Ausgang des Operationsverstärkers 2 ein Verhältnis des Gegenkopplungs-Widerstandes 4 und des Gatewiderstands 3 aussteuern, um die Spannung am negativen Eingang auf die des positiven Eingangs $V_{IN+}$ zu regeln. Die Klemmenverstärkung des Operationsverstärkers zwischen Eingangs- und Ausgangsklemme ist alleine durch den Gegenkopplungs-Widerstand 4 und den Gatewiderstand 3 gegeben.

Die Verstärkung der nichtinvertierenden Verstärkerschaltung 200 ist aufgrund der Temperaturabhängigkeit des Gatewiderstands 3 ein Maß für die Temperatur der Sperrschicht des Halbleiterleistungsschalters.

Fig. 2 zeigt ein vereinfachtes Modell eines Leistungs-MOSFETs 5, der einen Drainanschluss 6, einen Sourceanschluss 7 und einen Gateanschluss 8 aufweist. Der Leistungs-MOSFET 5 ist in die zuvor beschriebene Schaltung zur Messung der Temperatur der Sperrschicht eingesetzt. Neben dem eingebauten Gatewiderstand 3 ist auch die RC-Reihenschaltung 9 zur Modellierung der Eingangsimpedanzen an dem Sourceanschluss 7 und Drainanschluss 6 dargestellt. Ein Eingangskondensator 10 der RC-Reihenschaltung 9 symbolisiert die Kapazität des Gates, die eine intrinsische Eigenschaft eines jeden MOSFETs ist. Die in Reihe geschalteten Widerstände 3 sind eingebaut um eine gleichmäßige Spannungsverteilung über die jeweiligen MOSFETs auf dem Chip zu gewährleisten. Weiterhin ist ein gemeinsamer Eingangswiederstand 3 vorgesehen, der das Vorliegen von Schwingungen mit hohen Frequenzen verhindern soll. Die nichtinvertierende Verstärkerschaltung 200 arbeitet als Verstärker mit einem Verstärkungsfaktor gleich 1 für Gleichspannungssignale. In diesem Fall wird der Kondensator 10 des Leistungs-MOSFETs als Leerlauf behandelt und die restliche Schaltung gibt eine Verstärkung gleich 1 wieder. Mit einem Anstieg der Frequenz des Spannungssignals fängt die Schaltung an als Verstärker zu arbeiten.

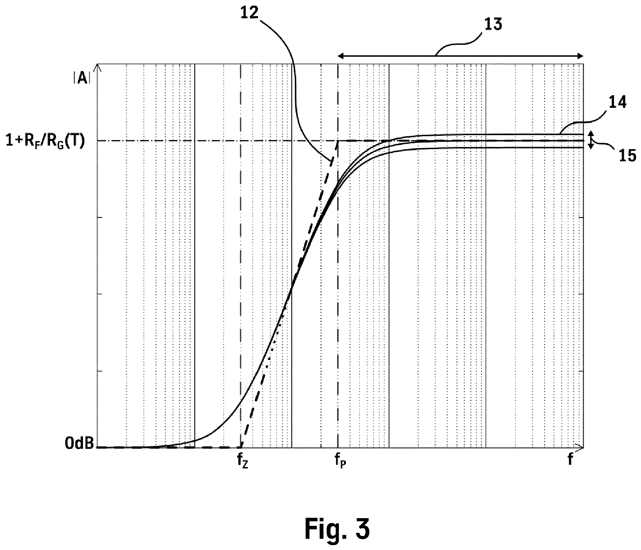

In Figur 3 ist die Übertragungsfunktion der nicht-invertierenden Verstärkerschaltung 14 dargestellt. Dabei ist die Verstärkung der nicht-invertierenden Verstärkerschaltung gegen die Frequenz aufgetragen.

Die asymptotisch angenähert Übertragungsfunktion einer idealen nicht-invertierenden Verstärkerschaltung 12 ist als gestrichelte Linie dargestellt.

Die Übertragungsfunktion der nicht-invertierenden Verstärkerschaltung 14 beinhaltet eine Nullstelle bei $f_Z$ und eine Polstelle bei fp, wobei die Frequenz der Nullstelle $f_Z$ immer kleiner ist als die Frequenz der Polstelle fp. Die Übertragungsfunktion zeigt somit die Charakteristiken eines Hochpassfilters. Im Falle der Verwendung eines echten Operationsverstärkers zeigen die Charakteristiken einen zusätzlichen Pol und eine durchlassband-ähnliche Filterung. Der horizontale Pfeil 13 zeigt den Frequenzbereich an, in dem das Signal von dem Filter verstärkt wird. In dem Bereich zwischen der Nullstelle und der Polstelle steigt die Verstärkung an, aber der Kondensator der RC-Reihenschaltung zeigt noch genug Impedanz um die kleinen temperaturbedingten Änderungen in dem Gatewiderstand zu überlagern, so dass diese in der Verstärkung nicht sichtbar sind. Für Frequenzen oberhalb der Polstelle hat die Impedanz des Kondensators geringen Einfluss mehr auf die Eingangsimpedanz und der Kondensator verhält sich, als ob er kurzgeschlossen wurde. Die Verstärkung ist abhängig von dem temperaturabhängigen Widerstand. Der vertikale Pfeil 15 deutet die temperaturbedingten Schwankung der gemessenen Verstärkung an.

Die Verstärkung v ist für Frequenzen oberhalb der Polstelle $f > f_P$ nur noch abhängig von dem Gatewidestand $R_G(T)$ und dem Gegenkopplungs-Widerstand $R_F$, wie bei einem normalen nichtinvertierenden Verstärker:

$$v(T) = 1 + \frac{R_F}{R_G(T)}.$$

Die Erfindung ist nicht auf MOSFETs begrenzt. Es können auch andere Halbleiterleistungsschaltelemente verwendet werden, die einen temperaturabhängigen Widerstand an einem Steuereingang aufweisen.

Halbleiterleistungsschaltelemente werden zum Beispiel in Phasenwindung eines Elektromotors einer Kraftfahrzeuglenkung bevorzugt in Form von Halbbrücken, insbesondere von einer dreifachen Halbbrücke für die Ansteuerung eines Dreiphasenmotors, eingesetzt. Die Wahl eines geeigneten Halbleiter-Bauelements ergibt sich durch das erwünschte Schaltverhalten. Als Halbleiterbauelemente werden vorzugsweise Leistungs-MOSFET verwendet, es können aber auch andere Bauelemente, wie bspw. IBGT, verwendet werden. Die mittels der erfindungsgemäßen Vorrichtung ermittelten Temperaturinformationen können z. B. dafür verwendet werden, die MOSFETs vor einer thermischen Überlastung zu schützen. Wird beispielsweise eine kritische Sperrschichttemperatur erreicht, kann eine Lenkunterstützung einer elektromechanischen Kraftfahrzeuglenkung reduziert und somit die Verlustleistung verringert werden.

**Patentansprüche**

**1.** Anordnung, umfassend:

- ein Halbleiterleistungsschaltelement (5) aufweisend einen Halbleiterleistungsschalter (1) mit einem eingebauten temperaturabhängigen Gatewiderstand (3); und
- eine Einrichtung zur Bestimmung einer Temperatur des Halbleiterleistungsschaltelementes (5),

**dadurch gekennzeichnet, dass** die Einrichtung eine nicht-invertierende Verstärkerschaltung (200), umfassend einen Operationsverstärker (2) und einen Gegenkopplungs-Widerstand (4), aufweist, wobei der invertierende Eingang des Operationsverstärkers (2) so an den Halbleiterleistungsschalter (1) angeschlossen ist, dass die Verstärkung der nicht-invertierenden Verstärkerschaltung (200) in einem vorgegebenen Frequenzbereich eines Eingangssignals ($V_{IN}$) von dem eingebauten temperaturabhängigen Gatewiderstand (3) und dem Gegenkopplungs-Widerstand (4) abhängt und ein Maß für die Temperatur des Halbleiterleistungsschaltelementes (5) ist.

**2.** Anordnung nach Anspruch 1, **dadurch gekennzeichnet, dass** der Gegenkopplungs-Widerstand (4) zwischen dem negativen Eingang und dem Ausgang des Operationsverstärkers (2) angeordnet ist.

**3.** Anordnung nach Anspruch 1 oder 2, **dadurch gekennzeichnet, dass** der temperaturabhängige Gatewiderstand (3) zwischen dem negativen Eingang des Operationsverstärkers (2) und einem Eingang der Einrichtung angeordnet ist.

**4.** Anordnung nach einem der vorhergehenden Ansprüche, **dadurch gekennzeichnet, dass** in dem vorgegeben Frequenzbereich des Eingangssignals ($V_{IN}$) der eingebaute temperaturabhängige Gatewiderstand (3) einen wesentlichen Teil der Eingangsimpedanz des Halbleiterleistungsschalters (1) bildet.

**5.** Anordnung nach einem der vorhergehenden Ansprüche, **dadurch gekennzeichnet, dass** der vorgegebene Frequenzbereich oberhalb einer Frequenz einer Polstelle ($f_P$) einer Übertragungsfunktion einer idealen nicht-invertierenden Verstärkerschaltung (12) liegt.

**6.** Anordnung nach einem der vorhergehenden Ansprüche, **dadurch gekennzeichnet, dass** das Halbleiterleistungsschaltelement (5) ein Leistungs-MOSFET oder IGBT ist.

**7.** Elektromechanische Kraftfahrzeuglenkung mit einem mehrphasigen permanent erregten Elektromotor, der über eine elektronische Steuereinheit ansteuerbar ist, wobei die elektronische Steuereinheit eine Vielzahl an Halbleiterleistungsschaltelementen (5) aufweist, die Teil eines Inverters und/oder als Halbleiterrelais in jeder Phase angeordnet sind, **dadurch gekennzeichnet, dass** jedes der Halbleiterleistungsschaltelemente Teil einer Anordnung nach einem der vorhergehenden Ansprüche ist.

**8.** Elektromechanische Kraftfahrzeuglenkung nach Anspruch 7, **dadurch gekennzeichnet, dass** der Elektromotor dreiphasig ist und zwei Halbleiterleistungsschaltelemente (5) pro Phase in einer Halbbrückenschaltung aufweist, die mittels Pulsweitenmodulation ansteuerbar sind.

**9.** Verfahren zur Messung einer Temperatur eines Halbleiterleistungsschaltelementes (5) aufweisend einen eingebauten temperaturabhängigen Gatewiderstand (3), wobei eine nicht-invertierende Verstärkerschaltung (200) aufweisend einen Operationsverstärker (2) und einen Gegenkopplungs-Widerstand (4), der zwischen dem negativen Eingang und dem Ausgang des Operationsverstärkers (2) angeordnet ist, wobei der temperaturabhängige Gatewiderstand (3) zwischen dem negativen Eingang des Operationsverstärkers (2) und einem Eingang der Gesamtschaltung angeordnet ist, und wobei das Verfahren folgende Schritte aufweist:

- Betreiben der Gesamtschaltung mit einem Eingangssignal ($V_{IN}$) aufweisend eine Frequenz, die in einem vorgegeben Frequenzbereich liegt, so dass der eingebaute temperaturabhängige Gatewiderstand (3) einen wesentlichen Teil der Eingangsimpedanz des Halbleiterleistungsschalters (1) bildet,
- Messen der Verstärkung der nicht-invertierenden Verstärkerschaltung (200),
- Berechnen des Widerstandes des eingebauten temperaturabhängigen Gatewiderstands (3) mittels der gemessenen Verstärkung und Bestimmen der Temperatur des Halbleiterleistungsschaltelementes (5).

**10.** Verfahren zum Messen einer Temperatur eines Halbleiterleistungsschaltelementes (5) mit einem eingebauten temperaturabhängigen Gate-Widerstand (3), wobei eine nicht-invertierende Verstärkerschaltung (200) aufweisend einen Operationsverstärker (2) und einen negativen Rückkopplungs-Widerstand (4), der zwischen dem negativen Eingang und dem Ausgang des Operationsverstärkers (2) angeordnet ist, und wobei der temperaturabhängige Gate-Widerstand (3) zwischen dem negativen Eingang des Operationsverstärkers (2) und einem Eingang der Gesamtschaltung angeordnet ist, und wobei das Verfahren die Schritte umfasst von:

- Betreiben der Gesamtschaltung mit einem Eingangssignal ($V_{IN}$) mit einer vorgegebenen Frequenz, die in einem vorbestimmten Frequenzbereich liegt, so dass der eingebaute temperaturabhängige Gatewiderstand (3) einen integralen Teil der Eingangsimpedanz des Halbleiterleistungsschalters (1) bildet Schalter,
- Messen des Ausgangssignals der nicht-invertierenden Verstärkerschaltung (200) für wenigstens zwei Temperatureinstellungen,
- Berechnen der Temperaturabhängigkeit des Ausgangssignals,
- Bestimmen der Temperatur des Halbleiterleistungsschaltelementes (5) basierend auf dem tatsächlichen Ausgangssignal und der berechneten Temperaturabhängigkeit.

**11.** Verfahren nach Anspruch 9 oder 10, **dadurch gekennzeichnet, dass** die bestimmte Temperatur ein Maß für die Sperrschichttemperatur des Halbleiterleistungsschaltelementes (5) ist.

**12.** Verfahren nach einem der vorhergehenden Ansprüche 9 bis 11, **dadurch gekennzeichnet, dass** das Halbleiterleistungsschaltelement (5) ein Leistungs-MOSFET oder IGBT ist.

**13.** Verfahren nach einem der vorhergehenden Ansprüche 9 bis 12, **dadurch gekennzeichnet, dass** der vorgegebene Frequenzbereich oberhalb einer Frequenz einer Polstelle ($f_P$) einer Übertragungsfunktion einer idealen nicht-invertierenden Verstärkerschaltung (12) liegt.

## Claims

**1.** Assembly comprising:

- a semiconductor power switching element (5) having a semiconductor power switch (1) with a built-in temperature-dependent gate resistor (3); and
- a device for determining a temperature of the semiconductor power switching element (1),

**characterized in that** the device has a non-inverting amplifier circuit (200) comprising an operational amplifier (2) and a feedback resistor (4), wherein the inverting input of the operational amplifier (2) is connected to the semiconductor power switch (1) in such a manner that the gain of the non-inverting amplifier circuit (200) in a predefined frequency range of an input signal ($V_{IN}$) depends on the built-in temperature-dependent gate resistor (3) and the feedback resistor (4) and is a measure of the temperature of the semiconductor power switching element (5).

**2.** The assembly as claimed in claim 1, **characterized in that** the feedback resistor (4) is arranged between the negative input and the output of the operational amplifier (2).

**3.** The assembly as claimed in claim 1 or 2, **characterized in that** the temperature-dependent gate resistor (3) is arranged between the negative input of the operational amplifier (2) and an input of the device.

**4.** The assembly as claimed in one of the preceding claims, **characterized in that**, in the predefined frequency range of the input signal ($V_{IN}$), the built-in temperature-dependent gate resistor (3) forms a substantial part of the input impedance of the semiconductor power switch (1).

**5.** The assembly as claimed in one of the preceding claims, **characterized in that** the predefined frequency range is above a frequency of a pole ($f_P$) of a transfer function of an ideal non-inverting amplifier circuit (12).

**6.** The assembly as claimed in one of the preceding claims, **characterized in that** the semiconductor power switching element (5) is a power MOSFET or an IGBT.

**7.** An electromechanical steering system of a motor vehicle having a multiphase permanently excited electric motor which can be controlled via an electronic control unit, wherein the electronic control unit has a multiplicity of semiconductor power switching elements (5) which are part of an inverter and/or are arranged as a semiconductor relay in each phase, **characterized in that** each of the semiconductor power switching elements (5) is part of an assembly as claimed in one of the preceding claims.

**8.** The electromechanical steering system of a motor vehicle as claimed in claim 7, **characterized in that** the electric motor is three-phase and has two semiconductor power switching elements (5) for each phase in a half-bridge circuit, which semiconductor power switching elements can be controlled by means of pulse width modulation.

**9.** A method for measuring a temperature of a semiconductor power switching element (5) having a built-in temperature-dependent gate resistor (3), wherein a non-inverting amplifier circuit (200) having an operational amplifier (2) and a feedback resistor (4), which is arranged between the negative input and the output of the operational amplifier (2), wherein the temperature-dependent gate resistor (3) is arranged between the negative input of the operational amplifier (2) and an input of the overall circuit, and wherein the method has the following steps of:

- operating the overall circuit with an input signal ($V_{IN}$) having a frequency which is in a predefined frequency range, in a manner such that the built-in temperature-dependent gate resistor (3) forms a substantial part of the input impedance of the semiconductor power switch (1),
- measuring the gain of the non-inverting amplifier circuit (200),
- calculating the resistance of the built-in temperature-dependent gate resistor (3) by means of the measured gain and determining the temperature of the semiconductor power switching element (5).

**10.** A method for measuring a temperature of a semiconductor power switching element (5) having a built-in temperature-dependent gate resistor (3), wherein a non-inverting amplifier circuit (200) having an operational amplifier (2) and a feedback resistor (4), which is arranged between the negative input and the output of the operational amplifier (2), and wherein the temperature-dependent gate resistor (3) is arranged between the negative input of the operational amplifier (2) and an input of the overall circuit, and wherein the method comprises the steps of:

- operating the overall circuit with an input signal ($V_{IN}$) having a predefined frequency which is in a predetermined frequency range, in a manner such that the built-in temperature-dependent gate resistor (3) forms an integral part of the input impedance of the semiconductor power switch (1),
- measuring the output signal from the non-inverting amplifier circuit (200) for at least two temperature settings,
- calculating the temperature dependence of the output signal,
- determining the temperature of the semiconductor power switching element (5) on the basis of the actual output signal and the calculated temperature dependence.

**11.** The method as claimed in claim 9 or 10, **characterized in that** the determined temperature is a measure of the junction temperature of the semiconductor power switching element (5).

**12.** The method as claimed in one of the preceding claims 9 to 11, **characterized in that** the semiconductor power switching element (5) is a power MOSFET or an IGBT.

**13.** The method as claimed in one of the preceding claims 9 to 12, **characterized in that** the predefined frequency range is above a frequency of a pole ($f_P$) of a transfer function of an ideal non-inverting amplifier circuit (12).

## Revendications

**1.** Agencement, comprenant :

- un élément disjoncteur à semi-conducteur (5) présentant un disjoncteur à semi-conducteur (1) pourvu d'une résistance de grille intégrée dépendant de la température (3) ; et
- un dispositif permettant de déterminer une température de l'élément disjoncteur à semi-conducteur (5),

**caractérisé en ce que** le dispositif présente un circuit amplificateur non inverseur (200), comprenant un amplificateur opérationnel (2) et une résistance de contre-réaction (4), l'entrée inverseuse de l'amplificateur opérationnel (2) étant connectée au disjoncteur à semi-conducteur (1) de telle sorte que l'amplification du circuit amplificateur non inverseur (200) dans une plage de fréquence prédéfinie dépend d'un signal d'entrée ($V_{IN}$) de la résistance de grille intégrée dépendant de la température (3) et de la résistance de contre-réaction (4) et est une mesure de la température de l'élément disjoncteur à semi-conducteur (5).

**2.** Agencement selon la revendication 1, **caractérisé en ce que** la résistance de contre-réaction (4) est disposée entre l'entrée négative et la sortie de l'amplificateur opérationnel (2).

**3.** Agencement selon la revendication 1 ou 2, **caractérisé en ce que** la résistance de grille dépendant de la température (3) est disposée entre l'entrée négative de l'amplificateur opérationnel (2) et une entrée du dispositif.

**4.** Agencement selon l'une quelconque des revendications précédentes, **caractérisé en ce que** dans la plage de fréquence prédéfinie du signal d'entrée ($V_{IN}$) la résistance de grille intégrée dépendant de la température (3) constitue une partie substantielle de l'impédance d'entrée du disjoncteur à semi-conducteur (1) .

**5.** Agencement selon l'une quelconque des revendications précédentes, **caractérisé en ce que** la plage de fréquence prédéfinie se situe au-dessus d'une fréquence d'un pôle ($f_P$) d'une fonction de transfert d'un circuit amplificateur non inverseur (12) idéal.

**6.** Agencement selon l'une quelconque des revendications précédentes, **caractérisé en ce que** l'élément disjoncteur à semi-conducteur (5) est un MOSFET de puissance ou un IGBT.

**7.** Direction électromécanique d'un véhicule automobile comprenant un moteur électrique polyphasé à excitation permanente qui peut être piloté par une unité de commande électronique, l'unité de commande électronique présentant une pluralité d'éléments disjoncteurs à semi-conducteur (5) qui font partie d'un inverseur et/ou sont disposés sous forme de relais à semi-conducteur dans chaque phase, **caractérisée en ce que** chacun des éléments disjoncteurs à semi-conducteur fait partie d'un agencement selon l'une quelconque des revendications précédentes.

**8.** Direction électromécanique d'un véhicule automobile selon la revendication 7, **caractérisée en ce que** le moteur électrique est triphasé et présente deux éléments disjoncteurs à semi-conducteur (5) par phase dans un circuit en demi-pont qui peuvent être pilotés par modulation d'impulsions en largeur.

**9.** Procédé permettant de mesurer une température d'un élément disjoncteur à semi-conducteur (5) présentant une résistance de grille intégrée dépendant de la température (3), dans lequel un circuit amplificateur non inverseur (200) présentant un amplificateur opérationnel (2) et une résistance de contre-réaction (4) qui est disposée entre l'entrée négative et la sortie de l'amplificateur opérationnel (2), la résistance de grille dépendant de la température (3) étant disposée entre l'entrée négative de l'amplificateur opérationnel (2) et une entrée du circuit global, et le procédé présentant les étapes suivantes consistant à :

- faire fonctionner le circuit global avec un signal d'entrée ($V_{IN}$) présentant une fréquence qui est située dans une plage de fréquence prédéfinie de sorte que la résistance de grille intégrée dépendant de la température (3) constitue une partie substantielle de l'impédance d'entrée du disjoncteur à semi-conducteur (1),
- mesurer l'amplification du circuit amplificateur non inverseur (200),
- calculer la résistance de la résistance de grille intégrée dépendant de la température (3) au moyen de l'amplification mesurée, et déterminer la température de l'élément disjoncteur à semi-conducteur (5).

**10.** Procédé permettant de mesurer une température d'un élément disjoncteur à semi-conducteur (5) avec une résistance de grille intégrée dépendant de la température (3), dans lequel un circuit amplificateur non inverseur (200) présentant un amplificateur opérationnel (2) et une résistance de rétroaction négative (4) qui est disposée entre l'entrée négative et la sortie de l'amplificateur opérationnel (2), et la résistance de grille dépendant de la température (3) étant disposée entre l'entrée négative de l'amplificateur opérationnel (2) et une entrée du circuit global, et le procédé comprenant les étapes consistant à :

- faire fonctionner le circuit global avec un signal d'entrée ($V_{IN}$) à une fréquence prédéfinie qui est située dans une plage de fréquence prédéterminée de sorte que la résistance de grille intégrée dépendant de la température (3) fait partie intégrante de l'impédance d'entrée du disjoncteur à semi-conducteur (1),
- mesurer le signal de sortie du circuit amplificateur non inverseur (200) pour au moins deux réglages de température,
- calculer la dépendance de la température du signal de sortie,
- déterminer la température de l'élément disjoncteur à semi-conducteur (5) sur la base du signal de sortie réel et de la dépendance de la température calculée.

**11.** Procédé selon la revendication 9 ou 10, **caractérisé en ce que** la température déterminée est une mesure de la température de jonction équivalente de l'élément disjoncteur à semi-conducteur (5).

**12.** Procédé selon l'une quelconque des revendications précédentes 9 à 11, **caractérisé en ce que** l'élément disjoncteur à semi-conducteur (5) est un MOSFET de puissance ou un IGBT.

**13.** Procédé selon l'une quelconque des revendications précédentes 9 à 12, **caractérisé en ce que** la plage de fréquence prédéfinie est située au-dessus d'une fréquence d'un pôle ($f_P$) d'une fonction de transfert d'un circuit amplificateur non inverseur (12) idéal.

V_IN+
2
+
−
V_OUT+
4
200
5
1
3
V_IN-
V_OUT-

Fig. 1

6
5
2
+
−
3
8
11
10
4
200
9
7

Fig. 2

12
13
|A|
14
1+R_F/R_G(T)
15
0dB
f_Z
f_P
f

Fig. 3

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Patentdokumente


- DE 102014204648 A1
- DE 102012102788 A1
- DE 102008063806 A1
- EP 2575255 A1
- US 2015092819 A1


### In der Beschreibung aufgeführte Nicht-Patentliteratur


- Operational Amplifier Applications for Audio Systems. **LOSMANDY et al.** JOURNAL OF THE AUDIO ENGINEERING SOCIETY. AUDIO ENGINEERING SOCIETY, 01. Januar 1969, vol. 17, 14-21